# EUROPÄISCHE PATENTSCHRIFT

(11) **EP 0 780 888 B1**
(45) Veröffentlichungstag und Bekanntmachung des Hinweises auf die Patenterteilung: **06.02.2002**
(21) Anmeldenummer: 96119052.7
(22) Anmeldetag: 27.11.1996
(51) Int. Cl.: H01L 21/28

(54) **Verfahren zur Herstellung einer Gateelektrode für eine MOS-Struktur**
Method of manufacturing a gate electrode for a MOS structure
Méthode de fabrication d'une électrode de porte pour une structure MOS

(30) Priorität: 21.12.1995 DE 19548056
(43) Veröffentlichungstag der Anmeldung: 25.06.1997
(73) Patentinhaber: Infineon Technologies AG, 81669 München (DE)
(72) Erfinder: Lustig, Bernhard, Dr., 81737 München (DE)
(74) Vertreter: Zedlitz, Peter, Dipl.-Inf.

(56) Entgegenhaltungen:
- EP-A- 0 402 296
- US-A- 4 358 340
- IBM TECHNICAL DISCLOSURE BULLETIN, Bd. 26, Nr. 9, 1.Februar 1984, Seiten 4587-4589, XP002000221 JOHNSON C ET AL: "METHOD FOR MAKING SUBMICRON DIMENSIONS IN STRUCTURES USING SIDEWALL IMAGE TRANSFER TECHNIQUES"

## Beschreibung

MOS-Strukturen mit kurzer Kanallänge, speziell Kurzkanal-MOSFETs, werden für schnelle Schaltungen benötigt. Kurzkanal-MOSFETs weisen eine kurze Gatelänge auf. Bei niedrigen Betriebsspannungen werden mit Kurzkanal-MOS-Transistoren kleine Gatterverzögerungszeiten erzielt.

Gateelektroden werden üblicherweise durch Strukturierung einer leitfähigen Schicht mit Hilfe einer photolithographisch erzeugten Maske gebildet. Gateelektroden mit Abmessungen unterhalb 100 nm, wie sie für Kurzkanal-MOS-Transistoren benötigt werden, sind unter Verwendung von optischer Lithographie nicht mehr zu strukturieren. Für diese Strukturgrößen ist zum Beispiel derzeit der Einsatz von Elektronenstrahllithographie erforderlich.

In US-A-4.358.340 ist vorgeschlagen, zur Herstellung einer Gateelektrode für eine MOS-Struktur auf einem Siliziumsubstrat zunächst eine Stufenstruktur aus SiO₂ zu bilden. Die Oberfläche des Siliziumsubstrats ist vollständig mit SiO₂ bedeckt. An einer Flanke der Stufenstruktur wird durch konforme Abscheidung einer Polysiliziumschicht und anisotropes Ätzen der Polysiliziumschicht ein Spacer erzeugt. Der Spacer wird schließlich als Ätzmaske verwendet, um die Stufenstruktur außerhalb des Spacers zu entfernen. Der Spacer wird dotiert und als Gateelektrode verwendet. Die Abmessung der Gateelektrode hängt von der Weite des Spacers am Fuß der Stufe ab und ist unabhängig von der minimal herstellbaren Strukturgröße in der verwendeten Lithographie. Bei diesem Verfahren besteht die Gefahr des Durchätzens des Gateoxids, insbesondere, wenn die Gateoxiddicke nur wenige Nanometer beträgt, was für sub-100 nm- Kurzkanaltransistoren unerläßlich ist.

Ein weiteres Verfahren zur Herstellung von Gatelektroden mit Strukturgrößen unterhalb der Auflösungsgrenze der verwendeten Lithographie ist aus C. Johnson et al, IBM Technical Disclosure Bulletin, Vol. 26, Nr. 9, 1984, Seiten 4587 bis 4589, bekannt. Dabei wird auf einem Substrat, das mit einem Gateoxid, einer Polysiliziumschicht und einer Siliziumdioxidschicht versehen ist, aus Photolack eine Struktur erzeugt, die eine im wesentlichen senkrechte Flanke aufweist. An der Flanke wird durch konforme Abscheidung und anschließendes anisotropes Ätzen einer Schicht aus Si₃N₄ oder SiO₂ ein Spacer erzeugt. Dieser Spacer wird als Ätzmaske zur Bildung der Gateelektrode durch Strukturierung der Polysiliziumschicht verwendet. Um ein Verfließen der Photolackstruktur bei der Bildung des Spacers zu vermeiden, wird der Photolack durch UV-Bestrahlung gehärtet. Nach Strukturierung der Gateelektrode wird der Spacer entfernt.

Der Erfindung liegt das Problem zugrunde, ein weiteres Verfahren zur Herstellung einer Gateelektrode für eine MOS-Struktur anzugeben, mit dem in der Gateelektrode Strukturgrößen kleiner als die Auflösungsgrenze der verwendeten Lithographie erzielt werden können.

Dieses Problem wird erfindungsgemäß gelöst durch ein Verfahren gemäß Anspruch 1. Weitere Ausgestaltungen der Erfindung gehen aus den übrigen Ansprüchen hervor.

In dem erfindungsgemäßen Verfahren wird die Gateelektrode durch Strukturierung einer Elektrodenschicht gebildet. Die laterale Ausdehnung der Gateelektrode wird durch einen Spacer bestimmt, der aus demselben Material wie die Gateelektrode gebildet wird. Unter Verwendung des Spacers als Ätzmaske wird eine Hartmaske gebildet, die zur Strukturierung der Gateelektrode verwendet wird. Bei der Strukturierung der Gateelektrode wird der aus demselben Material bestehende Spacer gleichzeitig mit entfernt. Ein separater Schritt zur Entfernung des Spacers entfällt somit. Dennoch wird die Gateelektrode mit im wesentlichen senkrechten Flanken erzeugt.

Da in dem erfindungsgemäßen Verfahren keine Lackmaske erforderlich ist, wird das Durchätzen extrem dünner Gatedielektrika bei der Gatestrukturierung vermieden.

Der Spacer wird an einer Flanke einer Stufe vorzugsweise durch Abscheidung einer Schicht mit konformer Kantenbedeckung und anschließendes anisotropes Ätzen der Schicht gebildet. Die Stufe wird in einer Hilfsschicht erzeugt, die die Oberfläche der Elektrodenschicht bedeckt.

Die Hilfsschicht wird durchgehend aus ein und demselben Material erzeugt. Die Höhe der Stufe wird über die Ätzzeit bei der Bildung der Stufe eingestellt. Dies hat den Vorzug, daß bei der Bildung der Hartmaske nur ein Ätzprozeß erforderlich ist. Vorzugsweise wird die Hilfsschicht aus TEOS-SiO₂ und die Elektrodenschicht und der Spacer aus Polysilizium gebildet. Diese Materialien sind in Standardprozessen mit guter Selektivität zueinander ätzbar.

Im folgenden wird die Erfindung anhand der Figuren und eines Ausführungsbeispiels näher erläutert.
- Figur 1: zeigt ein Halbleitersubstrat mit einem Gatedielektrikum, einer Elektrodenschicht, einer Hilfsschicht und einer Photolackmaske.
- Figur 2: zeigt das Halbleitersubstrat nach Bildung einer Stufe in der Hilfsschicht.
- Figur 3: zeigt das Halbleitersubstrat nach Abscheidung einer Schicht mit konformer Kantenbedeckung.
- Figur 4: zeigt das Halbleitersubstrat nach Bildung eines Spacers.
- Figur 5: zeigt das Halbleitersubstrat nach Bildung einer Hartmaske.
- Figur 6: zeigt das Halbleitersubstrat nach Bildung einer Gateelektrode durch Strukturierung der Elektrodenschicht.

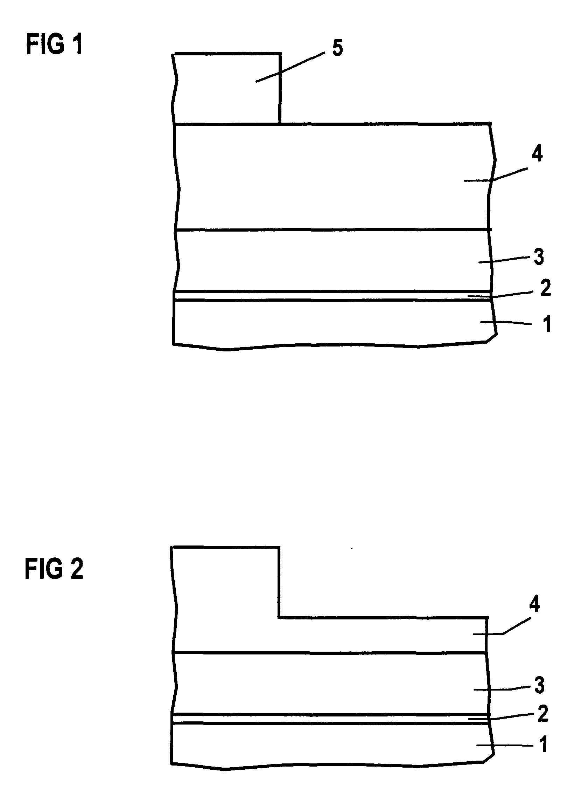

Auf ein Substrat 1, zum Beispiel eine monokristalline Siliziumscheibe oder ein SOI-Substrat wird ein Gatedielektrikum 2 aufgebracht. Das Gatedielektrikum 2 wird zum Beispiel durch thermische Oxidation aus SiO₂ in einer Schichtdicke von zum Beispiel 3 bis 4 nm gebildet (siehe Figur 1).

Auf das Gatedielektrikum 2 wird eine Elektrodenschicht 3 aufgebracht. Die Elektrodenschicht 3 besteht zum Beispiel aus dotiertem Polysilizium und weist eine Dicke von zum Beispiel 100 nm auf. Die Elektrodenschicht 3 ist zum Beispiel dotiert mit einer Dotierstoffkonzentration im Bereich 10²¹ cm⁻³.

Auf die Elektrodenschicht 3 wird eine Hilfsschicht 4 in einer Schichtdicke von zum Beispiel 200 nm aufgebracht. Die Hilfsschicht 4 wird zum Beispiel in einem TEOS-Verfahren aus SiO₂ gebildet.

Auf der Oberfläche der Hilfsschicht 4 wird eine Photolackmaske 5 erzeugt, die die Lage einer Flanke einer später herzustellenden Gateelektrode definiert.

Durch anisotropes Ätzen zum Beispiel mit CHF₃-RIE (Reactive Ion Etching) wird nachfolgend in der Hilfsschicht 4 eine Stufe mit einer im wesentlichen senkrechten Flanke erzeugt (siehe Figur 2). Die Stufe weist eine Höhe von zum Beispiel 150 nm auf. Die Oberfläche der Elektrodenschicht 3 bleibt daher von der stufenförmig strukturierten Hilfsschicht 4 bedeckt.

Die Höhe der Stufe wird über die Ätzzeit gesteuert. Anschließend wird die Photolackmaske 5 entfernt.

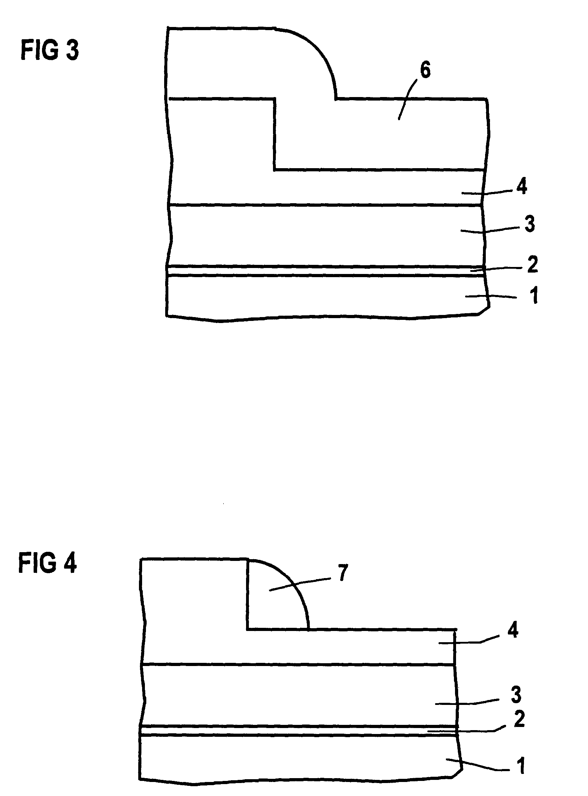

Es wird ganzflächig eine Schicht 6 mit im wesentlichen konformer Kantenbedeckung abgeschieden (siehe Figur 3). Die Schicht 6 wird zum Beispiel aus Polysilizium in einer Schichtdicke von zum Beispiel 100 nm abgeschieden.

Durch anisotropes Ätzen zum Beispiel mit HBr-RIE werden waagerechte Teile der Schicht 6 entfernt, und es verbleibt an der Flanke der stufenförmig strukturierten Hilfsschichtt 4 ein Spacer 7 (siehe Figur 4). Der Spacer 7 bildet in der Aufsicht eine geschlossene Kurve. Wenn diese Form für die Gateelektrode unerwünscht ist, kann der Spacer 7 mit Hilfe einer Lackmaske naßchemisch strukturiert werden (nicht dargestellt). Die Krümmung des Spacers 7 kann auf seinen oberen Teil beschränkt werden, indem man die Flanke der stufenförmig strukturierten Hilfsschicht höher ausführt.

Unter Verwendung des Spacers 7 als Ätzmaske wird anschließend die Hilfsschicht 4 strukturiert. Dabei entsteht aus der Hilfsschicht 4 eine Hartmaske 8. Besteht die Hilfsschicht 4 durchgehend aus zum Beispiel abgeschiedenem SiO₂ (TEOS), so erfolgt ihre Strukturierung zum Beispiel in einem anisotropen CHF₃ und CF₄-Ätzprozeß. Dieser weist eine gute Selektivität in Bezug auf Polysilizium auf, so daß die beim Ätzen der Hilfsschicht 4 auf der einen Seite des Spacers 7 zunächst freigelegte Oberfläche der Elektrodenschicht 3 nur geringfügig angeätzt wird.

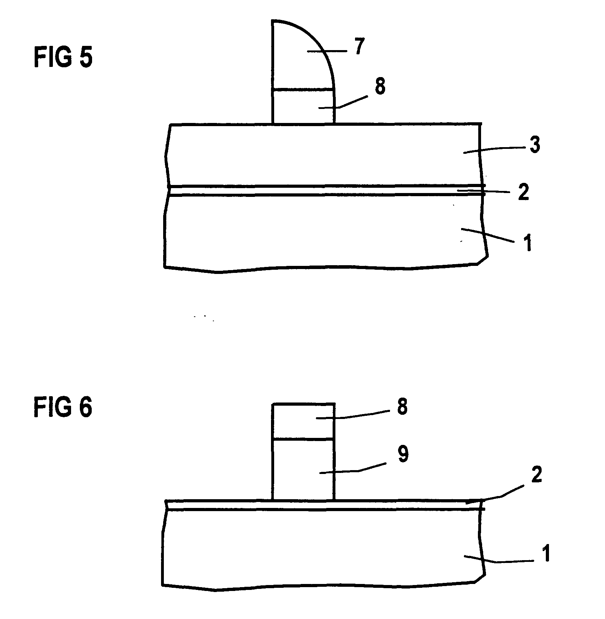

Schließlich wird die Elektrodenschicht 3 durch anisotropes Ätzen mit zum Beispiel HBr strukturiert. Dabei entsteht eine Gateelektrode 9. Gleichzeitig wird in diesem Ätzprozeß der Spacer 7, der aus demselben Material wie die Gateelektrode 9 besteht, entfernt (siehe Figur 6).

### Bezugszeichenliste

- 1: Substrat
- 2: Gatedielektrikum
- 3: Elektrodenschicht
- 4: Hilfsschicht
- 5: Photolackmaske
- 6: Schicht mit konformer Kantenbedeckung
- 7: Spacer
- 8: Hartmaske
- 9: Gateelektrode

## Patentansprüche

1. Verfahren zur Herstellung einer Gateelektrode einer MOS-Struktur,
- bei dem auf ein Halbleitersubstrat (1), das mit einem Gatedielektrikum (2) versehen ist, eine Elektrodenschicht (3) aufgebracht wird,
- bei dem auf die Elektrodenschicht (3) eine Hilfsschicht (4) aufgebracht wird,
- bei dem in der Hilfsschicht (4) eine Stufe erzeugt wird, wobei die Oberfläche der Elektrodenschicht (3) von der stufenförmig strukturierten Hilfsschicht (4) bedeckt bleibt,
- bei dem an der Stufe ein Spacer (7) gebildet wird,
- bei dem aus der stufenförmig strukturierten Hilfsschicht (4) durch anisotropes Ätzen unter Verwendung des Spacers (7) als Ätzmaske eine Hartmaske (8) gebildet wird,
- bei dem die Gateelektrode (9) durch anisotropes Ätzen der Elektrodenschicht (3) unter Verwendung der Hartmaske (8) als Ätzmaske gebildet wird,
- **dadurch gekennzeichnet, daß** der Spacer (7) aus dem Material der Elektrodenschicht (3) und die Hilfsschicht (4) und das Gatedielektrikum (2) unter Verwendung von nur einem Schichtmaterial gebildet werden.

2. Verfahren nach Anspruch 1,
bei dem der Spacer (7) durch Abscheidung einer Schicht (6) mit konformer Kantenbedeckung und anschließendes anisotropes Ätzen gebildet wird.

3. Verfahren nach Anspruch 1 oder 2,
bei dem die Hilfsschicht (4) und das Gatedielektrikum (2) aus SiO₂ und die Elektrodenschicht (3) und der Spacer aus Polysilizium gebildet werden.

## Claims

1. Method for fabricating a gate electrode of a MOS structure,
- in which an electrode layer (3) is applied to a semiconductor substrate (1) provided with a gate dielectric (2),
- in which an auxiliary layer (4) is applied to the electrode layer (3),
- in which a step is produced in the auxiliary layer (4), the surface of the electrode layer (3) remaining covered by the auxiliary layer (4) which is patterned in a step-shaped manner,
- in which a spacer (7) is formed on the step,
- in which a hard mask (8) is formed from the auxiliary layer (4), patterned in a step-shaped manner, by anisotropic etching using the spacer (7) as an etching mask,
- in which the gate electrode (9) is formed by anisotropic etching of the electrode layer (3) using the hard mask (8) as an etching mask,
- **characterized in that** the spacer (7) made of the material of the electrode layer (3) and the auxiliary layer (4) and the gate dielectric (2) are formed using just one layer material.

2. Method according to Claim 1,
in which the spacer (7) is formed by the deposition of a layer (6) with conformal edge coverage and subsequent anisotropic etching.

3. Method according to Claim 1 or 2,
in which the auxiliary layer (4) and the gate dielectric (2) are formed from SiO₂ and the electrode layer (3) and the spacer are formed from polysilicon.

## Revendications

1. Procédé de fabrication d'une électrode de grille d'une structure MOS,
- dans lequel on dépose sur un substrat (1) semiconducteur qui est muni d'un diélectrique (2) de grille une couche (3) d'électrode,
- dans lequel on dépose sur la couche (3) d'électrode une couche (4) auxiliaire,
- dans lequel on produit dans la couche (4) auxiliaire un épaulement, la surface de la couche (3) d'électrode restant revêtue de la couche (4) auxiliaire structurée à épaulement,
- dans lequel on forme sur l'épaulement un espaceur (7),
- dans lequel on forme à partir de la couche (4) auxiliaire structurée à épaulement, par attaque chimique anisotrope, en utilisant l'espaceur (7) comme masque d'attaque chimique, un masque (8) dur,
- dans lequel on forme l'électrode (9) de grille par attaque chimique anisotrope de la couche (3) d'électrode en utilisant le masque (8) dur comme masque d'attaque chimique,
- **caractérisé en ce que** l'on forme l'espaceur (7) en le matériau de la couche (3) d'électrode et la couche (4) auxiliaire et le diélectrique de grille en utilisant qu'un seul matériau de couche.

2. Procédé suivant la revendication 1, dans lequel on forme l'espaceur par dépôt d'une couche (6) à revêtement de bord conforme et attaque chimique anisotrope qui suit.

3. Procédé suivant la revendication 1 ou 2, dans lequel on forme la couche (4) auxiliaire et le diélectrique (2) de grille en SiO₂ et la couche (3) d'électrode et l'espaceur en polysilicium.
